# EUROPEAN PATENT APPLICATION

(11) **EP 4 597 492 A1**
(43) Date of publication of application: **06.08.2025**
(21) Application number: 25152020.1
(22) Date of filing: 15.01.2025
(51) Int. Cl.: G10L 21/034, H03G 3/32

(54) **AUDIO SIGNALS**

(30) Priority: 05.02.2024 GB 202401469
(71) Applicant: Nokia Technologies Oy, 02610 Espoo (FI)
(72) Inventor: VILERMO, Miikka Tapani, Siuro (FI); LEPPÄNEN, Jussi Artturi, Tampere (FI); LEHTINIEMI, Arto Juhani, Lempäälä (FI)
(74) Representative: Nokia EPO representatives

(57) **Abstract**

The specification describes an apparatus comprising: means for capturing audio signals corresponding to an audio capture session, wherein the audio signals comprise ambient audio and primary audio; means for determining a mute status of the audio capture session; means for controlling gain for at least one of the primary audio and ambient audio independent of the mute status.

## Description

### Field

The present specification relates to audio signals, particularly to controlling gain of audio signals.

### Background

Controlling gain of audio signals based on audio amplitude is known. There remains a need for improvement in controlling gain of audio signals in an audio capture session.

### Summary

According to a first aspect, there is provided an apparatus comprising: means for capturing audio signals corresponding to an audio capture session, wherein the audio signals comprise ambient audio and primary audio (e.g. audio comprising speech); means for determining a mute status of the audio capture session; and means for controlling gain for at least one of the primary audio and ambient audio independent of the mute status.

Some example embodiments further comprise means for controlling gain for at least one other of the primary audio and ambient audio dependent of the mute status.

Some example embodiments further comprise means for controlling gain of the primary audio dependent on the mute status. For example, controlling gain of the primary audio may be dependent on the mute status comprises suspending changes in gain for the primary audio for a first time period wherein the mute status is determined to be on for at least the first time period. Moreover, the means for controlling gain for the primary audio dependent on the mute status may comprise resuming changes in gain of the primary audio after at least one of: the first time period has passed or the mute status is determined to be off.

In some example embodiments, the means for controlling gain comprises means for controlling gain of the ambient audio independent of the mute status. Moreover, controlling gain of the ambient audio independent of the mute status may comprise attenuating the ambient audio if ambient audio amplitude is determined to be higher than a first ambient audio threshold, and amplifying the ambient audio if the ambient audio amplitude is determined to be lower than a second ambient audio threshold.

In some example embodiments, the means for controlling gain comprises means for controlling gain of the primary audio independent of the mute status. For example, controlling gain of the primary audio independent of the mute status comprises attenuating the primary audio if ambient audio amplitude is determined to be lower than a third ambient audio threshold, and amplifying the primary audio if the ambient audio amplitude is determined to be higher than a fourth ambient audio threshold. The apparatus may further comprise means for controlling gain of the primary audio for a second time period dependent on amplitude changes of the ambient audio and independent of amplitude changes of the primary audio, wherein the mute status is determined to be on for at least the second time period.

Some example embodiments further comprise means for generating a first ambient audio signal based on the gain control for the ambient audio; and means for generating a first primary audio signal based on the gain control for the primary audio. The apparatus may further comprise means for transmitting a combined audio signal comprising the first ambient audio signal and the first primary audio signal.

In some example embodiments, the said means comprise: at least one processor; and
at least one memory storing instructions that, when executed by the at least one processor, cause the apparatus at least to: capture audio signals corresponding to an audio capture session, wherein the audio signals comprise ambient audio and primary audio; determine a mute status of the audio capture session; and control gain for at least one of the primary audio and ambient audio independent of the mute status.

According to a second aspect, there is provided a method comprising: capturing audio signals corresponding to an audio capture session, wherein the audio signals comprise ambient audio and primary audio; determining a mute status of the audio capture session; and controlling gain for at least one of the primary audio and ambient audio independent of the mute status. The primary audio may comprises speech.

The method may further comprise controlling gain for at least one other of the primary audio and ambient audio dependent of the mute status.

The method may further comprise controlling gain of the primary audio dependent on the mute status. Controlling gain of the primary audio dependent on the mute status may comprise suspending changes in gain for the primary audio for a first time period wherein the mute status is determined to be on for at least the first time period. Moreover, controlling gain for the primary audio dependent on the mute status may comprise resuming changes in gain of the primary audio after at least one of: the first time period has passed or the mute status is determined to be off.

The method may comprise controlling gain by controlling gain of the ambient audio independent of the mute status. Controlling gain of the ambient audio independent of the mute status may comprise attenuating the ambient audio if ambient audio amplitude is determined to be higher than a first ambient audio threshold, and amplifying the ambient audio if the ambient audio amplitude is determined to be lower than a second ambient audio threshold.

Controlling gain may comprise controlling gain of the primary audio independent of the mute status. Controlling gain of the primary audio independent of the mute status may comprise attenuating the primary audio if ambient audio amplitude is determined to be lower than a third ambient audio threshold, and amplifying the primary audio if the ambient audio amplitude is determined to be higher than a fourth ambient audio threshold.

The method may further comprise controlling gain of the primary audio for a second time period dependent on amplitude changes of the ambient audio and independent of amplitude changes of the primary audio, wherein the mute status is determined to be on for at least the second time period.

The method may further comprise generating a first ambient audio signal based on the gain control for the ambient audio; and means for generating a first primary audio signal based on the gain control for the primary audio. The method may further comprise transmitting a combined audio signal comprising the first ambient audio signal and the first primary audio signal.

According to a third aspect, there is provided a computer-readable instructions which, when executed by a computing apparatus, cause the computing apparatus to perform (at least) any method as described herein (including the method of the second aspect described above).

According to a fourth aspect, there is provided a computer-readable medium (such as a non-transitory computer-readable medium) comprising program instructions stored thereon for performing (at least) any method as described herein (including the method of the second aspect described above).

According to a fifth aspect, there is provide an apparatus comprising: at least one processor; and at least one memory including computer program code which, when executed by the at least one processor, causes the apparatus to perform (at least) any method as described herein (including the method of the second aspect described above).

According to a sixth aspect, there is provided a computer program comprising instructions, which, when executed by an apparatus, cause the apparatus to: capture audio signals corresponding to an audio capture session, wherein the audio signals comprise ambient audio and primary audio; determine a mute status of the audio capture session; and control gain for at least one of the primary audio and ambient audio independent of the mute status.

According to a seventh aspect, there is provided an apparatus comprising (at least): a microphone (or some other means) for capturing audio signals corresponding to an audio capture session, wherein the audio signals comprise ambient audio and primary audio; a processor (or some other means) for determining a mute status of the audio capture session; the processor (or some other means) for controlling gain for at least one of the primary audio and ambient audio independent of the mute status.

### Brief description of the drawings

Example embodiments will now be described, by way of example only, with reference to the following schematic drawings, in which:
FIGs. 1 to 2 are block diagrams of systems in accordance with example embodiments;
FIG. 3 is a flowchart of an algorithm in accordance with an example embodiment;
FIG. 4 is a block diagram of a system in accordance with an example embodiment;
FIGs. 5 to 10 are flowcharts of algorithms in accordance with example embodiments;
FIG. 11 is a block diagram of components of a system in accordance with an example embodiment; and
FIG. 12 shows an example of tangible media for storing computer-readable code which when run by a computer may perform methods according to example embodiments described above.

### Detailed description

The scope of protection sought for various embodiments of the invention is set out by the independent claims. The embodiments and features, if any, described in the specification that do not fall under the scope of the independent claims are to be interpreted as examples useful for understanding various embodiments of the invention.

In the description and drawings, like reference numerals refer to like elements throughout.

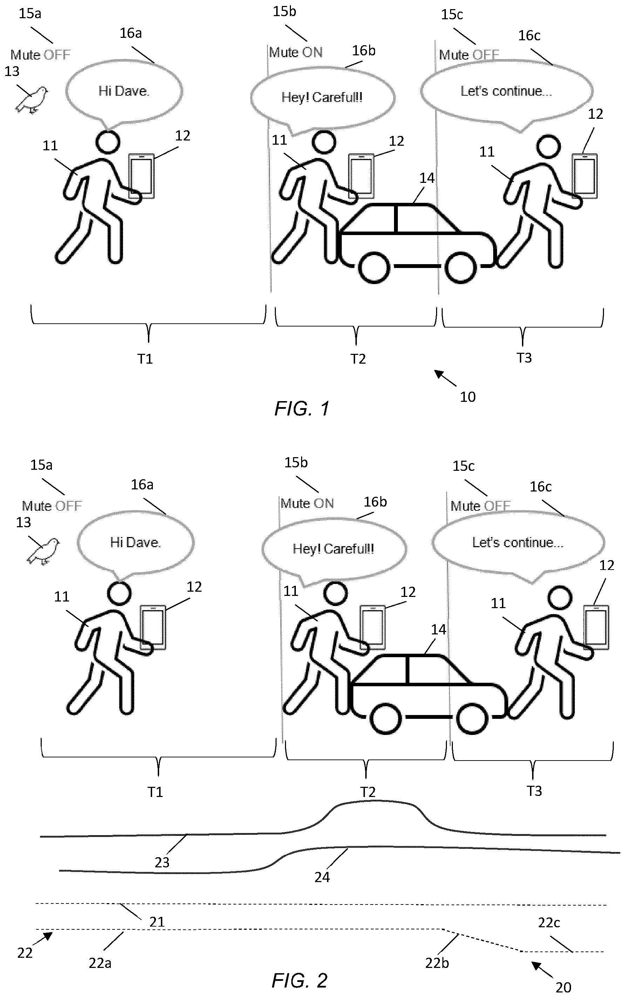

FIG. 1 is a block diagram of a system, indicated generally by the reference numeral 10, in accordance with an example embodiment.

System 10 shows a user 11 using a device 12 (e.g. a mobile communications device such as a smartphone, tablet, smartwatch, or the like) to communicate in an audio capture session. The device 12 may be used on its own (e.g. microphone and/or speaker part of the device 12), or may be used in conjunction with a peripheral device, such as an external audio device (e.g. microphone and/or speaker/headphones) for allowing the user to speak and/or hear communication for the audio capture session. The audio capture session may or may not further comprise video data communication. Although the audio capture session is shown to be a call between the user 11 and a recipient, the audio capture session may be any one of a call, a video/audio conference between multiple participants, a live streaming audio/video session, an audio/video recording, an audio/video communication in a virtual space (e.g. a game), or the like.

The device 12 and/or the peripheral device for device 12 may capture audio signals corresponding to the audio capture session. The audio signals may comprise ambient audio and primary audio (e.g. speech audio from the user 11).

System 10 shows the user 11 in a time period T1, T2, and T3 respectively (where the time periods are subsequent time periods in the order of T1 being an earliest time period, T2 being a middle time period, and T3 being the latest time period). For example, the user 11 may be walking on a road (e.g. where there may be loud ambient noise, or other distractions for user 11) while having an audio call with a colleague (e.g. Dave). The ambient noise may comprise sounds from nature, such as the bird 13, and/or sounds from traffic, such as the vehicle 14.

System 10 further shows mute status 15 for each of the time periods T1, T2, and T3. The mute status 15 may be controlled by the user 11, such that when the mute status is ON, audio from the user 11 and/or the ambient audio around the user 11 is muted, and when the mute status is OFF, audio from the user 11 and/or the ambient audio around the user 11 is unmuted and thus transmitted at the audio capture session (e.g. to the other side, such as transmitted to Dave's device).

At time period T1, a mute status 15a is OFF, and therefore audio signals (e.g. including primary audio and ambient audio) are captured and transmitted for the audio capture session. For example, the user 11 says "Hi Dave" as shown by the speech illustration 16a.

At time period T2, the vehicle 14 comes close to the user 11 (e.g. almost hitting the user 11), which may prompt the user 11 to react by raising his voice (e.g. shouting), for example, to say "Hey! Careful!!" as shown by the speech illustration 16b. At this time, it may be desirable for the user 11 to change the mute status to ON to avoid Dave hearing the user 11 shouting, and therefore the mute status 15b is ON. As the mute status 15b is ON, primary audio or ambient audio for the time period T2 is not transmitted to for the audio capture session.

At time period T3, a mute status 15c is OFF, as user 11 may again unmute the primary and/or ambient audio in order to resume speaking to Dave, for example saying "Lets continue..." (e.g. in normal tone, not shouting) as shown by the speech illustration 16c.

In general, gain control for primary audio may be performed such that as the amplitude of primary audio rises (audio gets louder), the gain for primary audio may be reduced, and as the amplitude of the primary audio reduces (audio gets softer), the gain for primary audio may be increased (e.g. in order to allow the listener to hear the audio louder).

FIG. 2 is a block diagram of a system, indicated generally by the reference numeral 20, in accordance with an example embodiment.

The system 20 shows the same scenario as that of system 10, and further provides an illustration 21 to show gain control of primary audio, and illustration 22 to show gain control of ambient audio.

During T1, when mute status 15a is OFF, gain control for the primary audio and ambient audio may be performed based on one or more of the respective primary audio amplitude and/or the ambient audio amplitude, as shown by the illustrations 21 and 22a.

For example, in general, while the mute status 15b is ON during time period T2, gain control for both the primary audio and the ambient audio may be suspended. As such, even though the user 11 raises their voice at time period T2 and the primary audio gets louder as shown by illustration 23, gain for the primary audio remains unchanged, as shown by the illustration 21. Further, as the vehicle 14 gets closer to the user 11, the sound from the vehicle 14 may also cause the ambient audio to get louder as shown by illustration 24. Even though the ambient audio gets louder at time period T2, the gain control for the ambient audio remains unchanged, as shown by the illustration 22a.

When the mute status 15c is OFF, gain control for the primary audio and the ambient audio may be resumed. As such, as the user 11 may return back to a normal voice (e.g. not shouting anymore as the user 11 themselves may have unmuted the audio), and therefore the gain remains unchanged at the time period T3. However, since the amplitude of the ambient audio may have become higher in time period T2 due to the vehicle 14 coming close to the user 11, the gain for the ambient audio is reduced over a time period as shown by the illustration 22b (e.g. lowered gradually over time shown by the slope of illustration 22b), as shown by the illustration 22c. However, the change in gain is started only after the mute is turned off. This may cause a delay in lowering the volume for the ambient audio, as the mute is already off in the beginning of T3, and at least some of the noise from the vehicle 14 may be heard at the audio capture session by the other side (e.g. by Dave), which may be undesirable. Some of the example embodiments described below provide techniques for avoiding this undesirable delay in change in gain due to mute status being on or off.

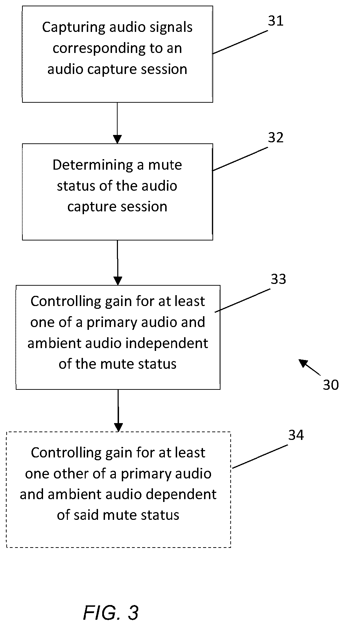

FIG. 3 is a flowchart of an algorithm, indicated generally by the reference numeral 30, in accordance with an example embodiment.

The algorithm 30 may start at operation 31, where audio signals corresponding to an audio capture session (e.g. call between the user 11 and Dave) may be captured. For example, the capturing may be performed at a device (e.g. device 12) or one or more peripheral devices (e.g. microphone and/or headphones connected to the device). The audio signals may comprise ambient audio and primary audio (e.g. speech audio).

Next, at operation 32, a mute status of said audio capture session may be determined. For example, the user (e.g. user 11) mutes their audio, the mute status is determined to be ON, and if the user (e.g. user 11) unmutes there audio, the mute status is determined to be OFF.

At operation 33, gain for at least one of the primary audio and the ambient audio is controlled independent of said mute status. For example, the gain for at least one of the primary audio and the ambient audio is controlled in the usual way (e.g. based on amplitude of the corresponding ambient audio or primary audio, e.g. reducing gain when amplitude high or increasing gain when amplitude low) regardless of the mute status being on or off.

At an optional operation 34, gain for at least one other of the primary audio and ambient audio is controlled dependent on the said mute status. For example, gain is not controlled in the usual way (e.g. reducing gain when amplitude high or increasing gain when amplitude low) while mute status is on.

For example, at operation 33, gain for the ambient audio is controlled independent of the mute status, whereas at an optional operation 34, gain for the primary audio is controlled dependent of the mute status.

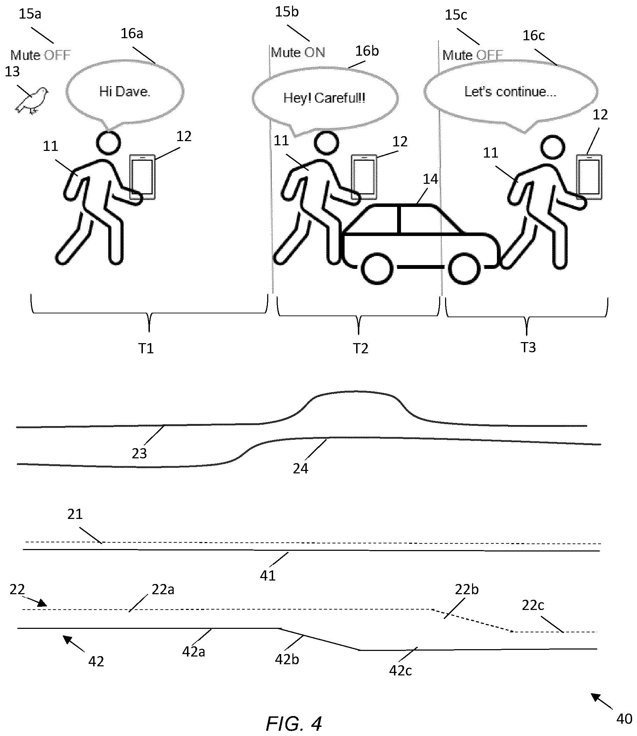

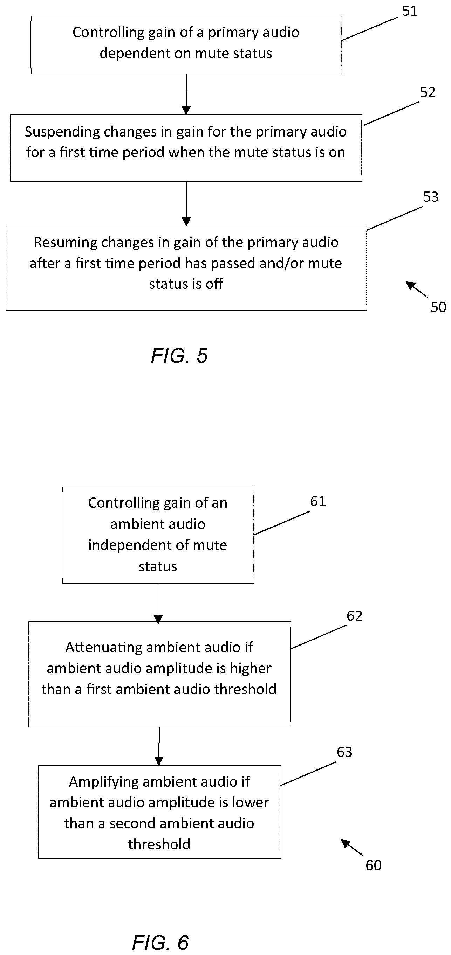

FIG. 4 is a block diagram of a system, indicated generally by the reference numeral 40, in accordance with an example embodiment. FIG. 4 is described in conjunction with FIGs. 5 and 6 for better understanding. FIG. 5 is a flowchart of an algorithm, indicated generally by the reference numeral 50, in accordance with an example embodiment. FIG. 6 is a flowchart of an algorithm, indicated generally by the reference numeral 60, in accordance with an example embodiment.

System 40 shows the user 11 in a similar scenario to system 20. In addition, system 40 shows illustration 41 to show an example gain control of the primary audio based on the algorithm 30 and 50, and illustration 42 to show an example gain control of the ambient audio based on the algorithm 30 and 60.

The algorithm 50 starts at operation 51, where gain of the primary audio may be controlled dependent on the mute status. For example, during T1, when mute status 15a is OFF, gain control for the primary audio may be performed based on one or more of the primary audio amplitude and/or the ambient audio amplitude, as shown by the illustration 41.

At operation 52, changes in gain may be suspended for a first time period (e.g. during time period T2), wherein the mute status is determined to be on for at least the first time period. For example, despite the user 11 raising their voice during T2, thus increasing the primary audio amplitude as shown by the illustration 23, the gain of the primary audio remains unchanged during T2, as shown by the illustration 41.

At operation 53, changes in gain of the primary audio may be resumed after at least one of: the first time period has passed or the mute status is determined to be off. For example, after T2 has passed, the mute status 15c is off, and therefore changes in gain of the primary audio may be resumed. As the user 11 may not be shouting anymore at T3, the gain of the primary audio remains same as before (e.g. same level as T1).

The algorithm 60 starts at operation 61, where gain of an ambient audio is controlled independent of the mute status. For example, gain control for the ambient audio may be performed based on one or more of the primary audio amplitude and/or the ambient audio amplitude at time periods T1, T2, and T3, regardless of the mute status being on or off, as shown by the illustration 42. For example, at T1, the ambient audio is shown to be unchanged, and therefore the gain for the ambient audio may remain unchanged, as shown by the illustration 42a.

At operation 62, ambient audio may be attenuated (e.g. gain for the ambient audio is reduced) if ambient audio amplitude is higher than a first ambient audio threshold. For example, as the ambient audio amplitude gets higher in T2 (shown by the illustration 24) as the vehicle 14 gets closer to user 11 (e.g. therefore noise from vehicle 14 getting louder), the gain for the ambient audio may be reduced, as shown by the illustration 42b. By the time that the mute status 15c is off, the gain for the ambient audio had already been reduced in T2, such that in T3, while the mute status 15c is off, the volume of the ambient audio transmitted for the audio capture session may not be too high despite the vehicle 14 being loud, as the gain for the ambient audio is reduced in response to the ambient audio amplitude increasing. This is different than the gain control of illustration 22, as the change in gain of the ambient audio is suspended during T2 due to mute status 15b being on, and gain control of the ambient audio is resumed when mute status 15c is off, thus causing a slight delay in the ambient audio volume actually being reduced which in turn causes a high volume of ambient audio being transmitted for the audio capture session, at least for the length of the time covered by the slope of the illustration 22b. For example, the gain control of illustration 42 may be preferable, as it avoids the volume of the ambient audio being transmitted at the audio capture session being too high, such that the user 11 may be heard relatively more clearly.

At operation 63, the ambient audio may be amplified (e.g. the gain for the ambient audio may be increased) if the ambient audio amplitude is determined to be lower than a second ambient audio threshold. For example, in system 40, if the ambient audio reduces some time after T3 (not shown), the gain for the ambient audio may be increased from the level shown by illustration 42c.

In an example embodiment, the gain for the ambient audio may be increased or reduced inversely proportional to the amplitude of the ambient audio independent of a mute status, and may not be dependent on the first or second ambient audio threshold. Alternatively, or in addition, the gain for the ambient audio may be increased or decreased proportional to the amplitude of the primary audio, and may not be dependent on the first or second ambient audio threshold.

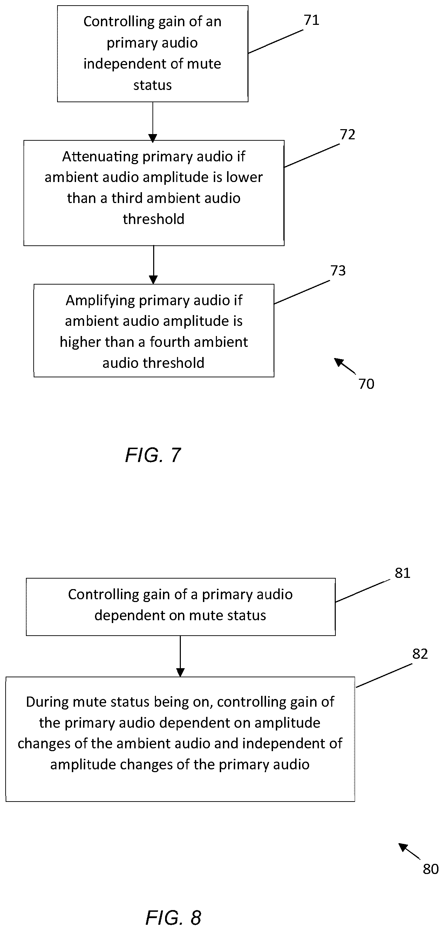

Fig. 7 is a flowchart of an algorithm, indicated generally by the reference numeral 70, in accordance with an example embodiment.

At operation 71, gain of a primary audio may be controlled independent of the mute status. For example, contrary to the gain control shown by illustration 41 in FIG. 4, gain control of the primary audio may not be suspended during T2 when mute status 15b is on.

At operation 72, the primary audio may be attenuated (e.g. gain for primary audio is reduced) if the ambient audio amplitude is lower than a third ambient audio threshold. As such, as the ambient audio becomes softer, it may be desirable to also allow the primary audio to be softer such that the primary audio does not overshadow the ambient audio significantly.

At operation 73, the primary audio may be amplified (e.g. gain for the primary audio is increased) if the ambient audio amplitude is higher than a fourth ambient audio threshold. As such, as the ambient audio becomes louder, it may be desirable to also allow the primary audio to be louder, such that the primary audio remains clear, and the ambient audio does not overshadow the primary audio significantly. For example, with reference to system 40, when the ambient audio amplitude increases in T2, the primary audio gain may be increased during T2 (even though the mute status is ON) in order to ensure that the speech of user 11 is clear over the ambient audio received from the vehicle 14.

In an example embodiment, the gain for the primary audio may be increased or reduced proportional to the amplitude of the ambient audio independent of a mute status, and may not be dependent on the third or fourth ambient audio threshold.

Fig. 8 is a flowchart of an algorithm, indicated generally by the reference numeral 80, in accordance with an example embodiment. At operation 81, gain of the primary audio may be controlled dependent on the mute status of an audio capture session. At operation 82, the control of the gain may comprise controlling gain of the primary audio during a second time period dependent on amplitude changes of the ambient audio, and independent of amplitude changes of the primary audio, The mute status is determined to be on for the second time period.

For example, the second time period may be the time period T2 in system 40, when the mute status 15b is on. During T2, the gain of the primary audio (e.g. speech of user 11) may be increased due to the amplitude of the ambient audio increasing. As such, changes in amplitude of the primary audio should not affect the gain of the primary audio while the mute status is on. However, after T2, when the mute status 15c is off, gain of the primary audio may additionally or alternatively be dependent on the amplitude of the primary audio.

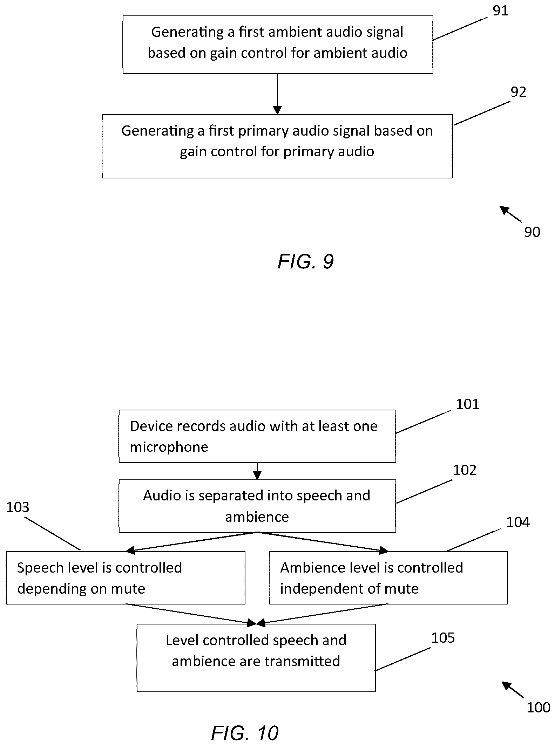

FIG. 9 is a flowchart of an algorithm, indicated generally by the reference numeral 90, in accordance with an example embodiment. At operation 91, a first ambient audio signal may be generated based on gain control for ambient audio, for example, the gain control described by one or more of the algorithms 30 and 60. At operation 92, a first primary audio signal may be generated based on gain control for primary audio, for example, the gain control described by one or more of the algorithms 30, 50, 70, and 80.

In an example embodiment, a combined audio signal may be transmitted, for example, for the audio capture session (e.g. transmitted to a device used by Dave in system 40). The combined audio signal may comprise at least the first ambient audio signal and the first primary audio signal.

FIG. 10 is a flowchart of an algorithm, indicated generally by the reference numeral 100, in accordance with an example embodiment. At operation 101, a device, such as the device 12, may record audio with at least one microphone (e.g. microphone comprised within the device 12 or an external microphone in a peripheral device such as headphones, or a standalone microphone). At operation 102, the recorded audio may be separated into a speech audio (e.g. primary audio described above) and an ambient audio. At operation 103, the speech level (e.g. gain of speech audio) may be controlled dependent on a mute status (e.g. similar to operations 51 to 53). At operation 104, the ambience level (e.g. gain of ambient audio) may be controlled independent of the mute status (e.g. similar to the operations 61 to 63). At operation 105, the level controlled speech and ambient audio (e.g. the speech gain controlled dependent on mute status and the ambience gain controlled independent of mute status) may be transmitted (e.g. for an audio capture session) as a combined signal comprising a level controlled speech audio signal and level controlled ambient audio signal.

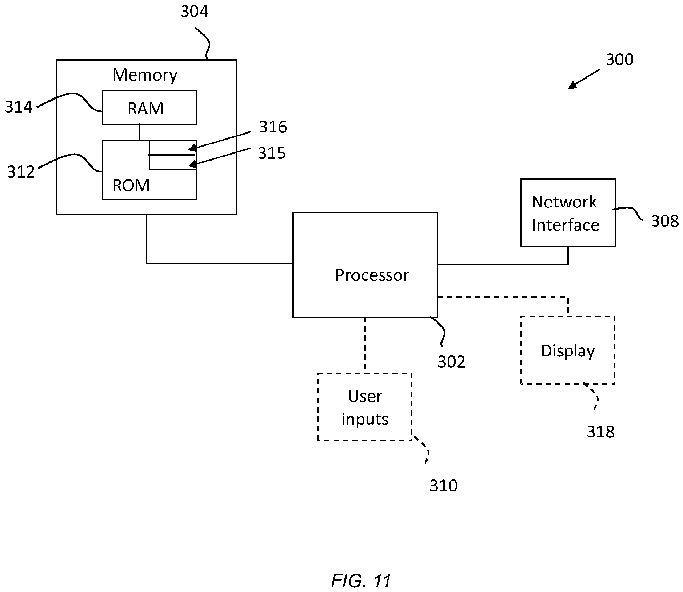

For completeness, FIG. 11 is a schematic diagram of components of one or more of the example embodiments described previously, which hereafter are referred to generically as processing systems 300. A processing system 300 may have a processor 302, a memory 304 closely coupled to the processor and comprised of a RAM 314 and ROM 312, and, optionally, user input 310 and a display 318. The processing system 300 may comprise one or more network/apparatus interfaces 308 for connection to a network/apparatus, e.g. a modem which may be wired or wireless. Interface 308 may also operate as a connection to other apparatus such as device/apparatus which is not network side apparatus. Thus, direct connection between devices/apparatus without network participation is possible.

The processor 302 is connected to each of the other components in order to control operation thereof.

The memory 304 may comprise a non-volatile memory, such as a hard disk drive (HDD) or a solid-state drive (SSD). The ROM 312 of the memory 304 stores, amongst other things, an operating system 315 and may store software applications 316. The RAM 314 of the memory 304 is used by the processor 302 for the temporary storage of data. The operating system 315 may contain computer program code which, when executed by the processor implements aspects of the algorithms 30, 50, 60, 70, 80, 90, and 100 described above. Note that in the case of small device/apparatus the memory can be most suitable for small size usage i.e. not always hard disk drive (HDD) or solid-state drive (SSD) is used.

The processor 302 may take any suitable form. For instance, it may be a microcontroller, a plurality of microcontrollers, a processor, or a plurality of processors.

The processing system 300 may be a standalone computer, a server, a console, or a network thereof. The processing system 300 and needed structural parts may be all inside device/apparatus such as IoT device/apparatus i.e. embedded to very small size

In some example embodiments, the processing system 300 may also be associated with external software applications. These may be applications stored on a remote server device/apparatus and may run partly or exclusively on the remote server device/apparatus. These applications may be termed cloud-hosted applications. The processing system 300 may be in communication with the remote server device/apparatus in order to utilize the software application stored there.

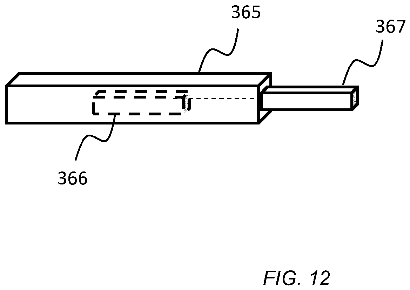

FIG. 12 shows tangible media, specifically a removable memory unit 365, storing computer-readable code which when run by a computer may perform methods according to example embodiments described above. The removable memory unit 365 may be a memory stick, e.g. a USB memory stick, having internal memory 366 for storing the computer-readable code. The internal memory 366 may be accessed by a computer system via a connector 367. Other forms of tangible storage media may be used. Tangible media can be any device/apparatus capable of storing data/information which data/information can be exchanged between devices/apparatus/network.

Embodiments of the present invention may be implemented in software, hardware, application logic or a combination of software, hardware and application logic. The software, application logic and/or hardware may reside on memory, or any computer media. In an example embodiment, the application logic, software or an instruction set is maintained on any one of various conventional computer-readable media. In the context of this document, a "memory" or "computer-readable medium" may be any non-transitory media or means that can contain, store, communicate, propagate or transport the instructions for use by or in connection with an instruction execution system, apparatus, or device, such as a computer.

Reference to, where relevant, "computer-readable storage medium", "computer program product", "tangibly embodied computer program" etc., or a "processor" or "processing circuitry" etc. should be understood to encompass not only computers having differing architectures such as single/multi-processor architectures and sequencers/parallel architectures, but also specialised circuits such as field programmable gate arrays FPGA, application specify circuits ASIC, signal processing devices/apparatus and other devices/apparatus. References to computer program, instructions, code etc. should be understood to express software for a programmable processor firmware such as the programmable content of a hardware device/apparatus as instructions for a processor or configured or configuration settings for a fixed function device/apparatus, gate array, programmable logic device/apparatus, etc.

As used in this application, the term "circuitry" refers to all of the following: (a) hardware-only circuit implementations (such as implementations in only analogue and/or digital circuitry) and (b) to combinations of circuits and software (and/or firmware), such as (as applicable): (i) to a combination of processor(s) or (ii) to portions of processor(s)/software (including digital signal processor(s)), software, and memory(ies) that work together to cause an apparatus, such as a server, to perform various functions) and (c) to circuits, such as a microprocessor(s) or a portion of a microprocessor(s), that require software or firmware for operation, even if the software or firmware is not physically present.

If desired, the different functions discussed herein may be performed in a different order and/or concurrently with each other. Furthermore, if desired, one or more of the above-described functions may be optional or may be combined. Similarly, it will also be appreciated that the flow charts of Figures 3, 5 to 10 are examples only and that various operations depicted therein may be omitted, reordered and/or combined.

It will be appreciated that the above described example embodiments are purely illustrative and are not limiting on the scope of the invention. Other variations and modifications will be apparent to persons skilled in the art upon reading the present specification.

Moreover, the disclosure of the present application should be understood to include any novel features or any novel combination of features either explicitly or implicitly disclosed herein or any generalization thereof and during the prosecution of the present application or of any application derived therefrom, new claims may be formulated to cover any such features and/or combination of such features.

## Claims

1. An apparatus comprising:
means for capturing audio signals corresponding to an audio capture session, wherein the audio signals comprise ambient audio and primary audio;
means for determining a mute status of the audio capture session;
means for controlling gain for at least one of the primary audio and ambient audio independent of the mute status.

2. An apparatus as claimed in claim 1, further comprising means for controlling gain for at least one other of the primary audio and ambient audio dependent of the mute status.

3. An apparatus as claimed in claim 1, further comprising controlling gain of the primary audio dependent on the mute status.

4. An apparatus as claimed in claim 3, wherein controlling gain of the primary audio dependent on the mute status comprises suspending changes in gain for the primary audio for a first time period wherein the mute status is determined to be on for at least the first time period.

5. An apparatus as claimed in claim 4, wherein the means for controlling gain for the primary audio dependent on the mute status comprises resuming changes in gain of the primary audio after at least one of: the first time period has passed or the mute status is determined to be off.

6. An apparatus as claimed in any one of the preceding claims, wherein the primary audio comprises speech.

7. An apparatus as claimed in any one of the preceding claims, wherein the means for controlling gain comprises means for controlling gain of the ambient audio independent of the mute status.

8. An apparatus as claimed in claim 7, wherein controlling gain of the ambient audio independent of the mute status comprises attenuating the ambient audio if ambient audio amplitude is determined to be higher than a first ambient audio threshold, and amplifying the ambient audio if the ambient audio amplitude is determined to be lower than a second ambient audio threshold.

9. An apparatus as claimed in any one of the preceding claims, wherein the means for controlling gain comprises means for controlling gain of the primary audio independent of the mute status.

10. An apparatus as claimed in claim 9, wherein controlling gain of the primary audio independent of the mute status comprises attenuating the primary audio if ambient audio amplitude is determined to be lower than a third ambient audio threshold, and amplifying the primary audio if the ambient audio amplitude is determined to be higher than a fourth ambient audio threshold.

11. An apparatus as claimed in one of claims 9 and 10, further comprising means for controlling gain of the primary audio for a second time period dependent on amplitude changes of the ambient audio and independent of amplitude changes of the primary audio, wherein the mute status is determined to be on for at least the second time period.

12. An apparatus as claimed in any one of the preceding claims, further comprising means for generating a first ambient audio signal based on the gain control for the ambient audio; and means for generating a first primary audio signal based on the gain control for the primary audio.

13. An apparatus as claimed in claim 12, further comprising means for transmitting a combined audio signal comprising the first ambient audio signal and the first primary audio signal.

14. A method comprising:
capturing audio signals corresponding to an audio capture session, wherein the audio signals comprise ambient audio and primary audio;
determining a mute status of the audio capture session;
controlling gain for at least one of the primary audio and ambient audio independent of the mute status.

15. A computer program comprising instructions, which, when executed by an apparatus, cause the apparatus to:
capture audio signals corresponding to an audio capture session, wherein the audio signals comprise ambient audio and primary audio;
determine a mute status of the audio capture session;
control gain for at least one of the primary audio and ambient audio independent of the mute status.
